# EUROPEAN PATENT SPECIFICATION

(11) **EP 1 508 674 B1**
(45) Date of publication and mention of the grant of the patent: **24.01.2007**
(21) Application number: 04016552.4
(22) Date of filing: 14.07.2004
(51) Int. Cl.: F01L 1/16, C23C 14/06, C23C 16/26, F01L 1/14

(54) **Tappet for internal combustion engine**
Tassenstössel für Brennkraftmaschine
Poussoir de soupapes

(30) Priority: 11.08.2003 JP 2003207037; 29.06.2004 JP 2004190969
(43) Date of publication of application: 23.02.2005
(73) Proprietor: NISSAN MOTOR COMPANY, LIMITED, Yokohama-shi, Kanagawa 221-0023 (JP)
(72) Inventor: Nishimura, Kimio, Yokohama-shi Kanagawa 224-0052 (JP); Hamada, Takahiro, Yokohama-shi Kanagawa 230-0051 (JP)
(74) Representative: Hoefer, Theodor

(56) References cited:
- EP-A- 0 435 312
- EP-A- 0 731 190
- US-A- 4 974 498
- US-A- 5 202 156
- US-A- 5 205 188
- PATENT ABSTRACTS OF JAPAN vol. 2000, no. 13, 5 February 2001 (2001-02-05) & JP 2000 297373 A (MIYAKE SHOJIRO; NISSAN MOTOR CO LTD), 24 October 2000 (2000-10-24) & DE 100 17 459 A (MIYAKE SHOJIRO ; NISSAN MOTOR (JP)) 26 October 2000 (2000-10-26)
- PATENT ABSTRACTS OF JAPAN vol. 0113, no. 30 (M-636), 28 October 1987 (1987-10-28) & JP 62 111106 A (HITACHI LTD; others: 01), 22 May 1987 (1987-05-22)

## Description

### CROSS-REFERENCE TO RELATED APPLICATIONS

This application has the following related applications: United States Patent Application Ser. Nos. 09/545,181 based on Japanese Patent Application Hei-11-102205 filed April 9, 1999; 10/468,713 which is the designated state (United States) application number of PCT Application JP02/10057 based on Japanese Patent Application 2001-117680 filed April 17, 2001; 10/355,099 based on Japanese Patent Application 2002-45576 filed February 22, 2002; 10/682,559 based on Japanese Patent Application 2002-302205 filed October 16, 2002; and 10/692,853 based on Japanese Patent Application 2002-322322 filed October 16, 2002.

### BACKGROUND OF THE INVENTION

This invention relates to improvements in a valve lifter interposed between a cam lobe of a camshaft and a valve stem so as to convert rotation of the camshaft to opening and closing actions of an intake or exhaust valve, for example, in an automotive internal combustion engine, more particularly to the improvements in the valve lifer for the internal combustion engine, formed of an aluminum alloy so as to be light in weight and low in friction.

In such a directly driven valve operating system in an automotive internal combustion engine that intake and exhaust valves are directly driven by a camshaft, a valve lifter formed of an iron-based material has been conventionally employed taking account of reliability. Additionally, the valve lifter in direct contact with the camshaft is produced upon being subjected to a treatment of nitriding made at the top surface thereof and a treatment for obtaining a mirror finished surface in order to ensure a wear resistance and to lower a friction.

In recent years, in order to improve a fuel economy, a weight-lightening is being accomplished by employing a valve lifter having no shim so as to reduce the load applied to a valve spring. Furthermore, it has been studied to form the valve lifter of an aluminum alloy in order to lighten the weight of the valve lifter itself, as disclosed in Japanese Patent Provisional Publication No. 11-22423.

### SUMMARY OF THE INVENTION

With the above conventional valve lifters, a major part of friction in the valve operating system is occupied by a friction between the top surface of the valve lifter and the cam lobe of the camshaft and another friction between the side surface of the valve lifter and the lifter bore of the cylinder head. On these days requiring improved fuel economy, it is very important to reduce such frictions; however, it will be understood that there is a limit to reduce the frictions with the above-discussed valve lifters having conventional structures.

It is, therefore, an object of the present invention to provide an improved valve lifter for an internal combustion engine, which can overcome drawbacks encountered in conventional valve lifters for internal combustion engines.

Another object of the present invention is to provide an improved valve lifter for an internal combustion engine, which can greatly reduce frictions between the valve lifter and opposite members, such as a friction between the top surface of the valve lifter and the cam lobe of a camshaft and another friction between the side surface of the valve lifter and the surface of a lifter bore, thereby improving performance and durability reliability of the engine while improving fuel economy of the engine.

An aspect of the present invention resides in a valve lifter for an internal combustion engine. The valve lifter comprises a main body formed of one of an aluminum alloy and an iron-based alloy as a base material and having a top surface and a side surface which are respectively in slidable contact with opposite members in presence of at least one of a lubricating oil and a lubricant. Additionally, a hard carbon thin film is formed on the main body to cover the top surface and the side surface, the hard carbon thin film containing hydrogen atom in an amount of not more than 1 atomic %.

Another aspect of the present invention resides in a method of producing a valve lifter for an internal combustion engine. The producing method comprises (a) preparing a main body of the valve lifter, formed of one of an aluminum alloy and an iron-based alloy as a base material and having a top surface and a side surface; and (b) forming a hard carbon thin film on the main body to cover the top surface and the side surface by a PVD process, the hard carbon thin film containing hydrogen atom in an amount of not more than 1 atomic %.

### BRIEF DESCRIPTION OF THE DRAWINGS

Fig. 1 is a vertical sectional view of an embodiment of a valve lifter for an internal combustion engine, according to the present invention; and
Fig. 2 is a vertical sectional view of a valve operating mechanism using the valve lifter of Fig. 1.

### DETAILED DESCRIPTION OF THE INVENTION

The present invention will be discussed below in detail. In the following description, all percentages (%) are by mass unless otherwise specified.

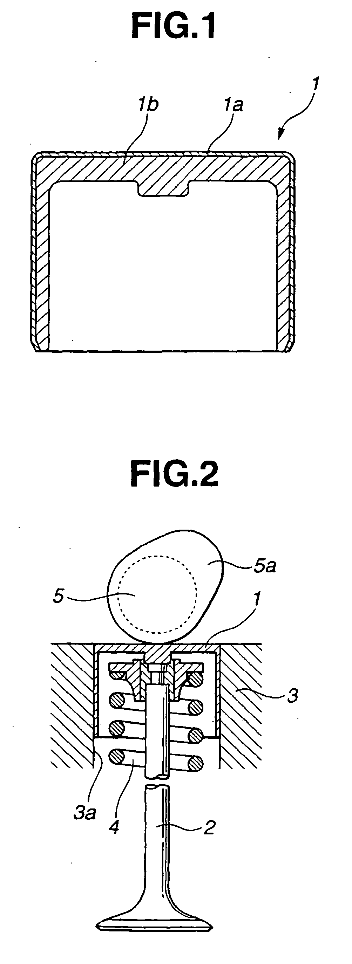

Referring now to Fig. 1, an embodiment of valve lifter 1 is shown including reversed cup-shaped main body or base material 1b formed of an aluminum alloy. The main body 1b may be formed of an iron-based alloy. Base material 1b has a cylindrical side wall section and an annular top wall section which are integral with each other. Hard carbon thin film 1 a is formed or coated at the outer peripheral surface of cylindrical side wall section and at the top or outer surface of top wall section. Hard carbon thin film 1a is contiguous to cover the whole outer peripheral surface of reversed cup-shaped base material 1b. Hard carbon thin film 1a has a hydrogen (atom) content of not more than 1 atomic %.

As shown in Fig. 2, valve lifter 1 forms part of a valve operating mechanism. Valve lifter 1 provided with hard carbon thin film 1 a is movably disposed within a lifter bore 3a of a cylinder head 3 and installed at the upper end of valve stem 2 forming part of an engine (intake or exhaust) valve. Valve stem 2 is biased upward together with valve lifter 1 by a compression coil spring 4 so as to maintain a valve closing condition of the engine valve. When camshaft 5 rotates, cam lobe 5a of camshaft 5 pushes downward valve lifter 1 together with valve stem 2 against the biasing force of coil spring 4, so that the valve opening and closing actions of the engine valve is carried out at a cycle in accordance with an engine speed of the engine.

In this embodiment, hard carbon thin film 1a containing hydrogen (atom) in an amount of not more than 1 atomic % is formed at the top surface and the cylindrical side surface of valve lifter 1. The top surface of valve lifter 1 is in slidable contact with cam lobe 5a of camshaft 5 as an opposite member. The cylindrical side surface of valve lifter 1 is in slidable contact with the cylindrical surface of lifter bore 3a of the cylinder head 3 as another opposite member. By virtue of this hard carbon thin film 1a, the above slidably contactable top and cylindrical side surfaces of valve lifter 1 is lowered in friction coefficient in presence of a lubricating oil and/or lubricant. Additionally, hard carbon thin film 1a is sufficiently high in hardness and therefore greatly improves a scuffing resistance and a wear resistance of the valve lifter, thereby contributing to improving performance and durability-reliability of the internal combustion engine.

Hard carbon thin film 1 a is formed of, for example, DLC (diamond-like carbon) material which is mainly constituted of carbon atom. The DLC material takes a diamond structure (SP³ bonding) and/or a graphite structure (SP² bonding) in bonding mode among carbons. More specifically, the hard carbon (DLC) thin film 1a is formed of hydrogen-free amorphous carbon (a-C) that consists of carbon, or metal carbide or metal carbon (MeC) that contains as a part a metal element of titanium (Ti) or Molybdenum (Mo). For a significant reduction in friction, it is necessary that the DLC material is as low as possible in hydrogen (atom) content and therefore has a hydrogen content of not more than 1 atomic %. As the hydrogen content in the hard carbon thin film increases, the friction coefficient increases. If the hydrogen content exceeds 1 atomic %, it is difficult to sufficiently lower the friction coefficient during slidable contact of the valve lifter to opposite members such as the cam lobe and the cylindrical surface of the lifter bore 3a.

The hard carbon thin film having such a low hydrogen content is obtained by a PVD process that substantially does not use hydrogen and/or hydrogen-containing compound, such as a sputtering process or an ion plating process. In this case, it is preferable to carrying out a film-forming operation for the hard carbon thin film upon baking of a reactor and tools for supporting the base material and upon sufficiently cleaning the surface of the base material in order to reduce the hydrogen content in the hard carbon thin film, in addition to using gas containing no hydrogen during the film-forming operation.

Next, the lubricating oil and/or lubricant (composition) used for the vale lifter according to the present invention will be discussed.

The lubricating oil and/or lubricant (composition) preferably includes a base oil and at least one of an ashless fatty acid ester (ester of fatty acid) friction modifier and an ashless aliphatic amine friction modifier. In other words, the ashless fatty acid ester friction modifier and/or aliphatic amine friction modifier are/is contained in the base oil. Such a lubricating oil and/or lubricant is presence at a slidably contacting surface formed between the top surface of valve lifter 1 and another slidably contacting surface formed between the cylindrical side surface of valve lifter 1 and the cylindrical surface of lifter bore 3a, thereby achieving an extremely low friction coefficient at the slidably contacting surfaces.

Here, the base oil is not particularly limited and can be any base oil (compound or compounds) commonly used for a lubricating oil and/or lubricant, such as a mineral oil, a synthetic oil, an oil and fat (compound), or any combination of the mineral oil, the synthetic oil and the oil and fat.

Specific examples of the mineral oil include paraffin-based or naphthene-based oil, and n-paraffin, prepared by extracting a lubricating oil and/or lubricant fraction from petroleum by atmospheric or reduced-pressure distillation, and then, purifying the obtained lubricating oil and/or lubricant fraction by using at least one of the following treatments: solvent deasphalting, solvent extraction, hydrogenolysis, solvent dewaxing, hydrogenation purification, sulfuric acid treatment, clay treatment and the like which may be used in suitable combination. It is general to purify the obtained lubricating oil and/or lubricant fraction by using hydrogenation purification or solvent purification. Additionally, it is preferable to use the mineral oil which is obtained by purifying the lubricating oil and/or lubricant fraction using high-hydrogenolysis process which is capable of largely decreasing aromatic components, or the mineral oil produced by a process for isomerizing GTL (gas to liquid) Wax.

Specific examples of the synthetic oil include: poly-α-olefins (such as 1-octene oligomer, 1-decene oligomer and ethylene-propylene oligomer), hydrides of poly-α-olefins, isobutene oligomers, hydrides of isobutene oligomers, isoparaffins, alkylbenzenes, alkylnaphthalenes, diesters (such as ditridecyl glutarate, dioctyl adipate, diisodecyl adipate, ditridecyl adipate and dioctyl sebacate), polyol esters (such as trimethylolpropane caprylate; trimetylolpropane pelargonate; trimethylolpropane ester such as trimethylolpropane isostearinate; pentaerythritol ester such as pentaerythritol-2-ethyl hexanoate and pentaerythritol pelargonate), polyoxyalkylene glycol, dialkyldiphenyl ether, and polyphenyl ether. Among these synthetic oil compounds, preferred are poly-α-olefins, such as 1-octene oligomer and 1-decene oligomer and hydrides thereof.

The above-mentioned mineral and synthetic oil (compounds) may be used alone, or in the form of a mixture of any two or more thereof with no limitation on the mixture ratio.

The sulfur content of the base oil is not particularly restricted. The sulfur content is preferably not more than 0.2 %, more preferably not more than 0.1 %, much more preferably not more than 0.05 %. Additionally, it is preferable to use, as the base oil, mineral oil which is purified by hydrogenation or synthetic oil because such oil has a sulfur content of not more than 0.005 % or substantially no sulfur content (not more than 5 ppm).

The aromatic content of the base oil is also not particularly restricted. The aromatic content of the base oil is preferably 15 % or less, more preferably 10 % or less, and most preferably 5 % or less in order that the lubricating oil and/or lubricant for internal combustion engines maintain its low friction characteristics for a long time. When the aromatic content exceeds 15%, the base oil undesirably deteriorates in oxidation stability. Herein, the aromatic content is defined as the amount of aromatics fractions determined according to ASTM D2549 "Standard Test Method for Separation of Representative Aromatics and Nonaromatics Fractions of High-Boiling Oils by Elution Chromatography".

The kinematic viscosity of the base oil is not particularly restricted. When the lubricating oil and/or lubricant is used for an internal combustion engine, the kinematic viscosity of the base oil is preferably 2 mm²/s or higher, more preferably 3 mm²/s and, at the same time, is preferably 20 mm²/s or lower, more preferably 10 mm²/s or lower, most preferably 8 mm²/s or lower, as measured at 100°C. When the kinematic viscosity is lower than 2 mm²/s at 100°C, the lubricating oil and/or lubricant can provide a sufficient wear resistance and be inferior in vaporization characteristics. When the kinematic viscosity exceeds 20 mm²/s, the lubricating oil and/or lubricant is difficult to exhibit a low frictional characteristics and may be degraded in vaporization characteristics, which are not preferable. In connection with the present invention, at least two base oils may be freely selected to be mixed to form a mixture, in which the kenematic viscosity of the single base oil may be out of the above-mentioned range as far as the kinematic viscosity of the mixture at 100 °C falls within the above-mentioned preferable range.

The viscosity index of the base oil is not particularly restricted, and is preferably 80 or higher, more preferably 100 or higher, most preferably 120 or higher, when the lubricating oil and/or lubricant is used for an internal combustion engine. Increasing the viscosity index of the base oil can provide the lubricating oil and/or lubricant for the internal combustion engine, excellent in low temperature viscosity characteristics and fuel economy performance.

Examples of the fatty acid ester friction modifier and the aliphatic amine friction modifier are an fatty acid ester and an aliphatic amine each having C₆-C₃₀ straight or branched hydrocarbon chains or groups, preferably C₈-C₂₄ straight or branched hydrocarbon chains, more preferably C₁₀-C₂₀ straight or branched hydrocarbon chains. When the carbon number of the hydrocarbon chain is not within the range of 6 to 30, there arises a possibility that the lubricating oil and/or lubricant may not produce a sufficient friction reducing effect as expected. It will be understood that a suitable mixture of fatty acid ester and the aliphatic amine may be used.

Specific examples of the C₆-C₃₀ straight or branched hydrocarbon chain include: alkyl groups, such as hexyl, heptyl, octyl, nonyl, decyl, undecyl, dodecyl, tridecyl, tetradecyl, pentadecyl, hexadecyl, heptadecyl, octadecyl, nonadecyl, icosyl, heneicosyl, docosyl, tricosyl, tetracosyl, pentacosyl, hexacosyl, heptacosyl, octacosyl, nonacosyl and triacontyl; and alkenyl groups, such as hexenyl, heptenyl, octenyl, nonenyl, decenyl, undecenyl, dodecenyl, tridecenyl, tetradecenyl, pentadecenyl, hexadecenyl, heptadecenyl, octadecenyl, nonadecenyl, icosenyl, heneicosenyl, docosenyl, tricosenyl, tetracosenyl, pentacosenyl, hexacosenyl, heptacosenyl, octacosenyl, nonacosenyl and triacontenyl. The above alkyl and alkenyl groups include all possible isomers. Additionally, the position of alkenyl groups is free.

The fatty acid ester can be exemplified by esters of fatty acids having the above C₆-C₃₀ hydrocarbon groups or chains and monohydric or polyhydric aliphatic alcohols. Specific examples of such fatty acid esters include glycerol monooleate, glycerol dioleate, sorbitan monoleate and sorbitan dioleate.

The aliphatic amine can be exemplified by aliphatic monoamines and alkylene oxide adducts thereof, aliphatic polyamines, imidazoline compounds, and derivatives thereof. Specific examples of such aliphatic amines include: aliphatic amine compounds, such as laurylamine, lauryldiethylamine, lauryldiethanolamine, dodecyldipropanolamine, palmitylamine, stearylamine, stearyltetraethylenepentamine, oleylamine, oleylpropylenediamine, oleyldiethanolamine and N-hydroxyethyloleylimidazolyne; adducts of the above aliphatic amines (C₆-C₂₈ alkyl or alkenyl amines) with alkylene oxides, such as N,N-dipolyoxyalkylene-N-alkylamines; and acid-modified compounds prepared by reacting the above aliphatic amines with C₂-C₃₀ monocarboxylic acids (such as fatty acids) or C₂-C₃₀ polycarboxylic acids (such as oxalic acid, phthalic acid, trimellitic acid and pyromellitic acid) so as to neutralize or amidate the whole or part of the remaining amino and/or imino groups. In connection with the present invention, N,N-dipolyoxyethylene-N-oleylamine is preferably used.

The amount of the fatty acid ester friction modifier and/or the aliphatic amine friction modifier added in the lubricating oil and/or lubricant is not particularly restricted, and is preferably 0.05 to 3.0%, more preferably 0.1 to 2.0%, and most preferably 0.5 to 1.4%, based on the total mass of the lubricating oil and/or lubricant. When the amount of the fatty acid ester friction modifier and/or the aliphatic amine friction modifier is less than 0.05%, there arises a possibility that the lubricating oil and/or lubricant may not produce a sufficient friction reducing effect. When the amount of the fatty acid ester friction modifier and/or the aliphatic amine friction modifier exceeds 3.0%, the lubricating oil and/or lubricant produce a good friction reducing effect but undesirably deteriorates in storage stability and compatibility to cause precipitations.

Further, the lubricating oil and/or lubricant preferably includes polybutenyl succinimide and/or a derivative thereof as an ashless dispersant. Specific examples of the polybutenyl succinimide usable in connection with the present invention include compounds represented by the following general formulas (1) and (2).

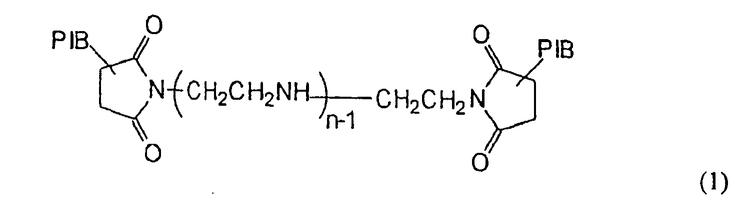

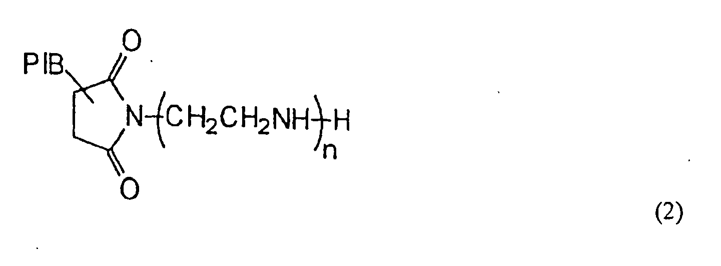

In each of the formulas (1) and (2), n represents an integer of 1 to 5, preferably 2 to 4, so as to attain a good detergent effect. Further, PIB represents a polybutenyl group derived from polybutene. The polybutene can be prepared by polymerizing high-purity isobutene or a mixture of 1-butene and isobutene in the presence of a boron fluoride catalyst or an aluminum chloride catalyst in such a manner that the polybutene attains a number-average molecular weight of 900 to 3,500, preferably 1,000 to 2,000. When the number-average molecular weight of the polybutene is less than 900, there is a possibility of failing to attain a sufficient detergent effect. When the number-average molecular weight of the polybutene exceeds 3,500, the polybutene may undesirably deteriorate in low-temperature fluidity. In the production of the polybutenyl succinimide, the polybutene may be used after purified by removing trace amounts of fluorine and chlorine residues, which result from the above polybutene production catalyst, by any suitable treatment (such as adsorption process or washing process). The amount of the fluorine and chlorine residues is preferably controlled to 50 ppm or less, more preferably 10 ppm or less, most preferably 1 ppm or less.

The production method of the polybutenyl succinimide is not particularly restricted. For example, the polybutenyl succinimide can be prepared by reacting an chloride of the above-mentioned polybutene, or the polybutene from which fluorine and chlorine residues are removed, with maleic anhydride at 100 to 200°C to form polybutenyl succinate, and then, reacting the thus-formed polybutenyl succinate with polyamine (such as diethylene triamine, triethylene tetramine, tetraethylene pentamine or pentaethylene hexamine).

The polybutenyl succinimide derivative can be exemplified by boron- and acid-modified compounds obtained by reacting the polybutenyl succinimide of the formulas (1) and (2) with boron compounds or oxygen-containing organic compounds so as to neutralize or amidate the whole or part of the remaining amino and/or imide groups. Among these, boron-containing polybutenyl succinimide, especially boron-containing bis(polybutenyl)succinimide, is preferably used.

The above boron compound can be a boric acid, a borate or a boric acid ester. Specific examples of the boric acid include orthoboric acid, metaboric acid and paraboric acid. Specific examples of the borate include: ammonium salts including ammonium borates, such as ammonium metaborate, ammonium tetraborate, ammonium pentaborate and ammonium octaborate. Specific examples of the boric acid ester include: esters of boric acids and alkylalcohols (preferably C₁-C₆ alkylalcohols), such as monomethyl borate, dimethyl borate, trimethyl borate, monoethyl borate, diethyl borate, triethyl borate, monopropyl borate, dipropyl borate, tripropyl borate, monobutyl borate, dibutyl borate and tributyl borate.. Herein, the content ratio of nitrogen to boron (B/N) by mass in the boron-containing polybutenyl succinimide is usually 0.1 to 3, preferably 0.2 to 1.

The above oxygen-containing organic compound can be exemplified by: C₁-C₃₀ monocarboxylic acids, such as formic acid, acetic acid, glycolic acid, propionic acid, lactic acid, butyric acid, valeric acid, caproic acid, enanthic acid, caprylic acid, pelargonic acid, capric acid, undecylic acid, lauric acid, tridecanoic acid, myristic acid, pentadecanoic acid, palmitic acid, margaric acid, stearic acid, oleic acid, nonadecanoic acid and eicosanoic acid; C₂-C₃₀ polycarboxylic acids, such as oxalic acid, phthalic acid, trimellitic acid and pyromellitic acid, and anhydrides and esters thereof; C₂-C₆ alkylene oxides; and hydroxy(poly)oxyalkylene carbonates.

The amount of the polybutenyl succinimide and/or the derivative thereof added in the lubricating oil and/or lubricant is not particularly restricted, and is preferably 0.1 to 15%, more preferably 1.0 to 12%, based on the total mass of the lubricating oil and/or lubricant. When the amount of the polybutenyl succineimide and/or the derivative thereof is less than 0.1 %, there arises a possibility of failing to attain a sufficient detergent effect. It becomes uneconomical when the amount of the polybutenyl succineimide and/or the derivative thereof exceeds 15%. In addition, such a large amount of the polybutenyl succineimide and/or the derivative thereof tends to cause a deterioration in demulsification ability.

Furthermore, the lubricating oil and/or lubricant preferably includes zinc dithiophosphate represented by the following general formula (3) as an antioxidant and as an anti-wear agent.

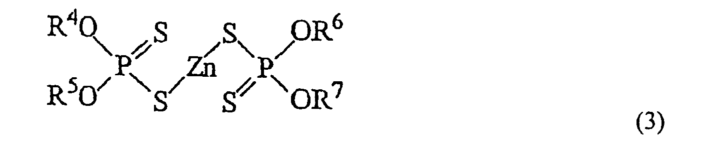

In the general formula (3), R⁴, R⁵, R⁶ and R⁷ each represent C₁-C₂₄ hydrocarbon groups. The C₁-C₂₄ hydrocarbon group is preferably a C₁-C₂₄ straight-chain or branched-chain alkyl group, a C₃-C₂₄ straight-chain or branched-chain alkenyl group, a C₅-C₁₃ cycloalkyl or straight-chain or branched-chain alkylcycloalkyl group, a C₆-C₁₈ aryl or straight-chain or branched-chain alkylaryl group, or a C₇-C₁₉ arylalkyl group. The above alkyl group or alkenyl group can be primary, secondary or tertiary. Specific examples of R⁴, R⁵, R⁶ and R⁷ include: alkyl groups, such as methyl, ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, icosyl, heneicosyl, docosyl, tricosyl and tetracosyl; alkenyl groups, such as propenyl, isopropenyl, butenyl, butadienyl, pentenyl, hexenyl, heptenyl, octenyl, nonenyl, decenyl, undecenyl, dodecenyl, tridecenyl, tetradecenyl, pentadecenyl, hexadecenyl, heptadecenyl, octadecenyl (oleyl), nonadecenyl, icosenyl, heneicosenyl, docosenyl, tricosenyl and tetracosenyl; cycloalkyl groups, such as cyclopentyl, cyclohexyl and cycloheptyl; alkylcycloalkyl groups, such as methylcyclopentyl, dimethylcyclopentyl, ethylcyclopentyl, propylcyclopentyl, ethylmethylcyclopentyl, trimetliylcyclopentyl, diethylcyclopentyl, ethyldimethylcyclopentyl, propylmethylcyclopentyl, propylethylcyclopentyl, di-propylcyclopentyl, propylethylmethylcyclopentyl, methylcyclohexyl, dimethylcyclohexyl, ethylcyclohexyl, propylcyclohexyl, ethylmethylcyclohexyl, trimethylcyclohexyl, diethylcyclohexyl, ethyldimethylcyclohexyl, propylmethylcyclohexyl, propylethylcyclohexyl, di-propylcyclohexyl, propylethylmethylcyclohexyl, methylcycloheptyl, dimethylcycloheptyl, ethylcycloheptyl, propylcycloheptyl, ethylmethylcycloheptyl, trimethylcycloheptyl, diethylcycloheptyl, ethyldimethylcycloheptyl, propylmethylcycloheptyl, propylethylcycloheptyl, di-propylcycloheptyl and propylethylmethylcycloheptyl; aryl groups, such as phenyl and naphthyl; alkylaryl groups, such as tolyl, xylyl, ethylphenyl, propylphenyl, ethylmethylphenyl, trimethylphenyl, butylphenyl, propylmethylphenyl, diethylphenyl, ethyldimethylphenyl, tetramethylphenyl, pentylphenyl, hexylphenyl, heptylphenyl, octylphenyl, nonylphenyl, decylphenyl, undecylphenyl and dodecylphenyl; and arylalkyl groups, such as benzyl, methylbenzyl, dimethylbenzyl, phenethyl, methylphenethyl and dimethylphenethyl. The above hydrocarbon groups include all possible isomers.

The above-mentioned hydrocarbon groups formable with R⁴, R⁵, R⁶ and R⁷ include all considerable straight or branched chain structures. The position of double bond of alkenyl group, the bonding position of alkyl group to cycloalkyl group and the bonding position of alkyl group to aryl group are free. Among the above-mentioned hydrocarbon groups, especially preferable ones are straight or branched alkyl groups having a carbon number ranging from 1 to 18, aryl groups having a carbon number ranging from 6 to 18, and straight or branched alkylaryl groups.

Specific examples of the zinc dithiophosphate usable in connection with the present invention include zinc diisopropyldithiophosphate, zinc diisobutyldithiophosphate, zinc di-sec-butyldithiophosphate, zinc di-sec-pentyldithiophosphate, zinc di-n-hexyldithiophosphate, zinc di-sec-hexyldithiophosphate, zinc di-octyldithiophosphate, zinc di-2-ethylhexyldithiophosphate, zinc di-n-decyldithiophosphate, zinc di-n-dodecyldithiophosphate, zinc diisotridecyldithiophosphate and mixtures thereof.

The amount of the zinc dithiophosphate added in the lubricating oil and/or lubricant is not particularly restricted. The zinc dithiophosphate is preferably contained in an amount of 0.1 % or less, more preferably in an amount of 0.06% or less, most preferably in a minimum effective amount, in terms of the phosphorus element based on the total mass of the lubricating oil and/or lubricant in order to produce a higher friction reducing effect. When the amount of the zinc dithiophosphate exceeds 0.1 %, there arises a possibility of inhibiting the effect of the ashless fatty acid ester friction modifier and/or the ashless aliphatic amine friction modifier, particularly at a sliding surface (plane) between the DLC thin film and the opposite member formed of iron-based material.

The zinc dithiophosphate can be prepared by any known method. For example, the zinc dithiophosphate may be prepared by reacting alcohols or phenols having the above R⁴, R⁵, R⁶ and R⁷ hydrocarbon groups with phosphorous pentasulfide to form dithiophosphoric acid, and then, neutralizing the thus-formed dithiophosphoric acid with zinc oxide. Herein, the molecular structure of zinc dithiophosphate differs according to the alcohols or phenols used as a raw material for the zinc dithiophosphate production. It will be understood that at least two kinds of zinc dithiophosphates represented by the above general formula (3) may be mixed at suitable ratio so as to be used.

As discussed above, in connection with the present invention, the lubricating oil and/or lubricant can exhibit an extremely excellent low friction characteristics in case that it is used at the sliding surface between the hard carbon thin film (formed of DLC) and metal materials. In order to raise performances required particularly for the lubricating oil and/or lubricant (composition) of internal combustion engines, the lubricating oil and/or lubricant may contain other additives, such as a metallic detergent, an antioxidant, a viscosity index improver, a friction modifier other than the above-mentioned fatty acid ester friction modifier and/or the aliphatic amine friction modifier, an ashless dispersant other than the above-mentioned polybutenyl succinimide and/or the derivative thereof, an anti-wear agent or extreme-pressure additive, a rust inhibitor, a nonionic surfactant, a deemulsifier, a metal deactivator and/or an anti-foaming agent, when used in an internal combustion engine. These additives may be used alone or in the form of a mixture of two or more thereof so as to meet the lubricating oil and/or lubricant performance required.

The metallic detergent can be any metallic-detergent compound commonly used for a lubricating oil and/or lubricant. Specific examples of the metallic detergent usable in connection with the present invention include sulfonates, phenates and salicylates of alkali metals or alkali-earth metals; and mixtures of two or more thereof. Examples of the alkali metals include sodium (Na) and potassium (K), and examples of the alkali-earth metals include calcium (Ca) and magnesium (Mg). In connection with the present invention, sodium and calcium sulfonates, sodium and calcium phenates, and sodium and calcium salicylates are suitably used. The total base number and amount of the metallic detergent can be selected in accordance with the lubricating oil and/or lubricant performance required. The total base number of the metallic detergent is usually 0 to 500 mgKOH/g; preferably 150 to 400 mgKOH/g, as measured by perchloric acid method according to ISO 3771 "Determination of base number - Perchloric acid potentiometric titration method". The amount of the metallic detergent is usually 0.1 to 10% based on the total mass of the lubricating oil and/or lubricant.

The antioxidant can be any antioxidant compound commonly used for a lubricating oil and/or lubricant. Specific examples of the antioxidant usable in connection with the present invention include: phenolic antioxidants, such as 4,4'-methylenebis(2,6-di-tert-butylphenol) and octadecyl-3-(3,5-di-tert-butyl-4-hydroxyphenyl)propionate; amino antioxidants, such as phenyl-α-naphthylamine, alkylphenyl-α-naphthylamine and alkyldiphenylamine; and mixtures of two or more thereof. The amount of the antioxidant is usually 0.01 to 5% based on the total mass of the lubricating oil and/or lubricant.

The viscosity index improver can be exemplified by:
non-dispersion type viscosity index improvers, such as copolymers of one or two monomers selected from various methacrylic acids, and hydrides of the copolymers; and dispersion type viscosity index improvers, such as copolymers of methacrylates (including nitrogen compounds). There may be also used, as the viscosity index improver, copolymers of ethylene and α-olefins (such as propylene, 1-butene and 1-pentene) and hydrides thereof, polyisobutylenes and hydrides thereof, a hydrogenated copolymer of styrene and diene, a copolymer of styrene and maleic anhydride and polyalkylstyrenes. The molecular weight of the viscosity index improver needs to be selected in view of shear stability. For example, the number-average molecular weight of the viscosity index improver is desirably in a range of 5,000 to 1,000,000, more desirably 100,000 to 800,000, for dispersion or non-dispersion type polymethacrylates; in a range of 800 to 5,000 for polyisobutylenes and hydrides thereof; and in a range of 800 to 300,000, more desirably 10,000 to 200,000 for ethylene/α-olefin copolymers and hydrides thereof. The above viscosity index improving compounds can be used alone or in the form of a mixture of two or more thereof. The amount of the viscosity index improver is preferably 0.1 to 40.0% based on the total mass of the lubricating oil and/or lubricant.

The friction modifier other than the above-mentioned fatty acid ester friction modifier and/or the aliphatic amine friction modifier can be exemplified by ashless friction modifiers, such as boric acid esters, higher alcohols and aliphatic ethers, and metallic friction modifiers, such as molybdenum dithiophosphate, molybdenum dithiocarbamate and molybdenum disulfide.

The ashless dispersant other than the above-mentioned polybutenyl succinimide and/or the derivative thereof can be exemplified by polybutenylbenzylamines and polybutenylamines each having polybutenyl groups of number-average molecular weight of 900 to 3,500, polybutenyl succinimides having polybutenyl groups of number-average molecular weight of less than 900 and derivatives thereof.

The anti-friction agent or extreme-pressure additive can be exemplified by disulfides, sulfurized fats and oils, olefin sulfides, phosphate esters having one to three C₂-C₂₀ hydrocarbon groups, thiophosphate esters, phosphite esters, thiophosphite esters and amine salts of these esters.

The rust inhibitor can be exemplified by alkylbenzene sulfonates, dinonylnaphthalene sulfonates, esters of alkenylsuccinic acids and esters of polyhydric alcohols.

The nonionic surfactant and the deemulsifier can be exemplified by noionic polyalkylene glycol surfactants, such as polyoxyethylene alkylethers, polyoxyethylene alkylphenyleters and polyoxyethylene alkylnaphthyleters.

The metal deactivator can be exemplified by imidazoline compounds, pyrimidine derivatives, thiazole and benzotriazole.

The anti-foaming agent can be exemplified by silicones, fluorosilicones and fluoroalkylethers.

Each of the friction modifier other than the fatty acid ester friction modifier and/or the aliphatic amine friction modifier, the ashless dispersant other than the polybutenyl succinimide and/or the derivative thereof, the anti-wear agent or extreme-pressure additive, the rust inhibitor and the demulsifier is usually contained in an amount of 0.01 to 5% based on the total mass of the lubricating oil and/or lubricant, and the metal deactivator is contained in an amount of 0.0005 to 1% based on the total mass of the lubricating oil and/or lubricant.

It will be understood that a further friction lowering effect can be obtained by supplying the lubricant whose main component is a compound containing hydroxyl group, to the sliding surface between the valve lifter of the present invention and the opposite member formed of an aluminum alloy or an iron-based alloy. Preferable examples of the lubricant whose main component is the compound containing hydroxyl group are alcohols, particularly glycerol and ethylene glycol.

### EXPERIMENT 1

The present invention will be more readily understood with reference to the following Examples in comparison with Comparative Examples; however, these Examples are intended to illustrate the invention and are not to be construed to limit the scope of the invention.

### EXAMPLE 1

A generally semicylindrical test piece as a base material having a dimension of 8 x 12 x 40 mm was cut out from a raw material of an aluminum alloy for a valve lifter. The test piece had a semicylindical surface which longitudinally extends and had a radius of curvature of 17 mm. A DLC film was formed at the semicylindrical surface of this test piece by an arc ion plating process (PVD), thereby producing a specimen corresponding to the valve lifter. The DLC thin film had a hydrogen (atom) content of 0.2 atomic %, a Knoop hardness Hk of 2170 kg/mm², a maximum height (surface roughness) Ry of 0.03 µm, and a thickness h of 0.5 µm. The maximum height Ry was explained as R_{z} in JIS (Japanese Industrial Standard) B 0601 (:2001).

For an opposite specimen, a plate-shaped test piece having a dimension of 40 x 60 x 7 mm was cut out from a raw material AC2A (Al-Cu-Si based) according to JIS H5202. The plate-shaped test piece was finished to have a sliding surface having a surface roughness Ra of 0.1 µm, and then subjected to a so-called T7 heat treatment, thus producing the opposite specimen corresponding to an opposite member with which the valve lifter was in slidable contact. The surface roughness Ra is explained as Rₐ₇₅ in JIS (Japanese Industrial Standard) B 0601 (:2001). In the T7 heat treatment, the test piece underwent a solution treatment, followed by undergoing an overaging treatment.

Then, the specimen in combination with the opposite specimen underwent a frictional wear test in which the specimen made reciprocating motions relative to the opposite specimen in a state where the semicylindrical surface of the specimen was in slidable contact with the surface of the sliding surface of the opposite specimen. The frictional wear test was conducted in a lubricating oil (composition) H shown in Table 1 so as to determine a friction coefficient.

### EXAMPLE 2

Procedure of Example 1 was repeated to produce the specimen and the opposite specimen. The specimen in combination with the opposite specimen underwent a frictional wear test in which the specimen made reciprocating motions relative to the opposite specimen in a state where the semicylindrical surface of the specimen was in slidable contact with the surface of the sliding surface of the opposite specimen. The frictional wear test was conducted in a lubricating oil (composition) A shown in Table 1 so as to determine a friction coefficient.

### EXAMPLE 3 to EXAMPLE 8

Procedure of Example 1 was repeated to produce the specimen and the opposite specimen. The specimen in combination with the opposite specimen underwent each of frictional wear tests in which the specimen made reciprocating motions relative to the opposite specimen in a state where the semicylindrical surface of the specimen was in slidable contact with the surface of the sliding surface of the opposite specimen. The frictional wear tests were conducted respectively in lubricating oils (compositions) B, C, D, E, F and G shown in Table 1 so as to determine friction coefficients.

### EXAMPLE 9

Procedure of Example 1 was repeated to produce the specimen and the opposite specimen. The specimen in combination with the opposite specimen underwent a frictional wear test in which the specimen made reciprocating motions relative to the opposite specimen in a state where the semicylindrical surface of the specimen was in slidable contact with the surface of the sliding surface of the opposite specimen. The frictional wear test was conducted in a lubricating oil or lubricant (composition) which was glycerol, so as to determine a friction coefficient.

### COMPARATIVE EXAMPLE 1

A generally semicylindrical test piece as a base material having a dimension of 8 x 12 x 40 mm was cut out from a raw material of an aluminum alloy for a valve lifter. The test piece had a semicylindical surface which longitudinally extends and had a radius of curvature of 17 mm. A treatment for forming a Ni-P coating was made at the semicylindrical surface of this test piece, thereby producing a specimen corresponding to the valve lifter. For an opposite specimen, a plate-shaped test piece having a dimension of 40 x 60 x 7 mm was cut out from a raw material AC2A (Al-Cu-Si based) according to JIS H5202. The plate-shaped test piece was finished to have a sliding surface having a surface roughness Ra of 0.1 µm, and then subjected to a so-called T7 heat treatment, thus producing the opposite specimen corresponding to an opposite member with which the valve lifter was in slidable contact. The surface roughness Ra is explained as Rₐ₇₅ in JIS (Japanese Industrial Standard) B 0601 (:2001). In the T7 heat treatment, the test piece underwent a solution treatment, followed by undergoing an overaging treatment.

Then, the specimen in combination with the opposite specimen underwent a frictional wear test in which the specimen made reciprocating motions relative to the opposite specimen in a state where the semicylindrical surface of the specimen was in slidable contact with the surface of the sliding surface of the opposite specimen. The frictional wear test was conducted in a lubricating oil (composition) H shown in Table 1 so as to determine a friction coefficient.

### COMPARATIVE EXAMPLE 2

A generally semicylindrical test piece as a base material having a dimension of 8 x 12 x 40 mm was cut out from a raw material of an iron-based alloy (stainless steel, SUS 304 according to JIS) for a valve lifter. The test piece had a semicylindical surface which longitudinally extends and had a radius of curvature of 17 mm. The semicylindrical surface of this test piece was lapped, thereby producing a specimen corresponding to the valve lifter. For an opposite specimen, a plate-shaped test piece having a dimension of 40 x 60 x 7 mm was cut out from a raw material AC2A (Al-Cu-Si based) according to JIS H5202. The plate-shaped test piece was finished to have a sliding surface having a surface roughness Ra of 0.1 µm, and then subjected to a so-called T7 heat treatment, thus producing the opposite specimen corresponding to an opposite member with which the valve lifter was in slidable contact. The surface roughness Ra is explained as Rₐ₇₅ in JIS (Japanese Industrial Standard) B 0601 (:2001). In the T7 heat treatment, the test piece underwent a solution treatment, followed by undergoing an overaging treatment.

Then, the specimen in combination with the opposite specimen underwent a frictional wear test in which the specimen made reciprocating motions relative to the opposite specimen in a state where the semicylindrical surface of the specimen was in slidable contact with the surface of the sliding surface of the opposite specimen. The frictional wear test was conducted in a lubricating oil (composition) H shown in Table 1 so as to determine a friction coefficient.

### [Evaluation of Performance]

Each of the specimens of Examples and Comparative Examples underwent the frictional wear (reciprocating) test using a test apparatus, in which a tip section (having the semicylindrical surface) of the specimen of Examples and Comparative Examples was pressed on the surface of the plate-shaped opposite specimen with a load P, upon which the specimen made its reciprocating motion. During making the reciprocating motion of the specimen, a friction coefficient was measured at a turning end of a region in which the reciprocating motion was made. Results of this test are tabulated in Table 2. The frictional wear (reciprocating) test was carried out under the following test conditions:
Specimen: Semicylindrical, having the dimension of 8 x 12 x 40 mm and formed of aluminum alloy or iron-based alloy;
Opposite specimen: plate-shaped, having a dimension of 40 x 60 x 7 mm, and formed of material AC2A;
Test apparatus: Reciprocating motion-type;
Reciprocating motions of specimen: 600 cycles (reciprocating motions) per minute;
Test temperature: 25 °C;
Pressing load (P): 10 kgf; and
Measuring time: 60 min. after initiation of the test.

**TABLE 1**

| Lubricating oil (composition) | | | A | B | C | D | E | F | G | H |
|---|---|---|---|---|---|---|---|---|---|---|
| Composition (mass%) | Base oil | Mineral oil ¹⁾ | 100 | 100 | - | 100 | 100 | 100 | 100 | 100 |
| | | Synthetic oil ²⁾ | - | - | 100 | - | - | - | - | - |
| | Additives | Ester friction modifier ³⁾ | 1.0 | 1.0 | 1.0 | - | 1.0 | 1.0 | 0.2 | - |
| | | Amine friction modifier ⁴⁾ | - | - | - | 1.0 | - | 0.5 | - | - |
| | | Ashless dispersant ⁵⁾ | 5.0 | 5.0 | 5.0 | 5.0 | 5.0 | 5.0 | 5.0 | 5.0 |
| | | Zinc dithiophosphate (in terms of phosphorous element) ⁶⁾ | 0.00 | 0.047 | 0.047 | 0.047 | 0.094 | 0.094 | 0.047 | 0.094 |
| | | Metallic detergent (in terms of metal element) ⁷⁾ | 0.15 | 0.15 | 0.15 | 0.15 | 0.15 | 0.15 | 0.15 | 0.15 |
| | | Others ⁸⁾ | 0.50 | 0.50 | 0.50 | 0.50 | 0.50 | 0.50 | 0.50 | 0.50 |
| | | Others ⁹⁾ | 0.90 | 0.90 | 0.90 | 0.90 | 0.90 | 0.90 | 0.90 | 0.90 |
| Properties | Kinematic viscosity at 100°C mm²/s | | 10.3 | 10.2 | 10.0 | 10.2 | 10.3 | 10.3 | 10.3 | 10.3 |
| | Total base number according to perchloric acid method mgKOH/g | | 6.2 | 6.2 | 6.2 | 6.2 | 6.5 | 6.5 | 6.5 | 6.5 |
| | Total base number according to hydrochloric acid method mgKOH/g | | 4.5 | 4.5 | 4.5 | 4.5 | 5.2 | 5.2 | 5.2 | 5.2 |

| | | | | | | | | | | |
|---|---|---|---|---|---|---|---|---|---|---|
| [Note] ¹⁾ Hydrocracked mineral oil (kinematic viscosity at 100°C: 5.0mm²/s, viscosity index: 120, aromatic content: 5.5 mass%) ²⁾ 1-Decene oligomer hydride (kinematic viscosity at 100°C: 3.9mm²/s,viscosity index: 124, aromatic content: 0.0 mass%) ³⁾ Glycerol monooleate ⁴⁾ N, N-dipolyoxyethylene-N-oleylamine ⁵⁾ Polybutenyl succinimide (nitrogen content: 1.2mass%) ⁶⁾ Zinc dialkyldithiophosphate (zinc content: 9.3 mass%, phosphrous content: 8.5 mass%, alkyl group: secondary butyl or hexyl group) ⁷⁾ Calcium sulfonate (total base number: 300 mgKOH/g, calcium content: 12.0 mass%) ⁸⁾ Calcium phenate (total base number: 255 mgKOH/g, calcium content: 9.2 mass%) ⁹⁾ Including viscosity index improver, antioxidant, rust inhibitor, demulsifier, nonionic surfactant, metal deactivator and anti-foaming agent | | | | | | | | | | |

**Table 2**

| Item | Specimen | Opposite specimen | Lubricating oil or lubricant (composition) | Friction coefficient |
|---|---|---|---|---|
| Example 1 | DLC thin film | AC2A | H | 0.08 |
| Example 2 | DLC thin film | AC2A | A | 0.05 |
| Example 3 | DLC thin film | AC2A | B | 0.08 |
| Example 4 | DLC thin film | AC2A | C | 0.09 |
| Example 5 | DLC thin film | AC2A | D | 0.11 |
| Example 6 | DLC thin film | AC2A | E | 0.11 |
| Example 7 | DLC thin film | AC2A | F | 0.11 |
| Example 8 | DLC thin film | AC2A | G | 0.08 |
| Example 9 | DLC thin film | AC2A | Glycerol | 0.07 |
| Comparative Example 1 | Ni-P coating | AC2A | H | 0.13 |
| Comparative Example 2 | SUS 304 | AC2A | H | 0.13 |

The test results in Table 2 reveals that by forming the hard carbon thin film such as the DLC thin film at the sliding surface and/or by using the lubricating oil containing the ester additive and/or the lubricant (glycerol), the friction coefficient can be sharply lowered while the scuffing resistance and wear resistance are expected to be improved.

As appreciated from the above, according to the present invention, the hard carbon thin film having a hydrogen content of not more than 1 atomic % is formed at the top and side surfaces of the valve lifter which surfaces are sliding surfaces to the opposite members. Accordingly, the friction coefficient and friction resistance between the valve lifter and the opposite members can be sharply reduced while sharply reducing wear amounts of the valve lifter and the opposite members. This largely contributes to improving fuel economy and durability-reliability of internal combustion engines.

Although the invention has been described above by reference to certain embodiments and examples of the invention, the invention is not limited to the embodiments and examples described above. Modifications and variations of the embodiments and examples described above will occur to those skilled in the art, in light of the above teachings. The scope of the invention is defined with reference to the following claims.

## Claims

1. A valve lifter (1) for an internal combustion engine, comprising
a main body (1b) formed of one of an aluminum alloy and an iron-based alloy as a base material and having a top surface and a side surface which are respectively in slidable contact with opposite members in presence of at least one of a lubricating oil and a lubricant; and
a hard carbon thin film (1a) formed on the main body to cover the top surface and the side surface, the hard carbon thin film containing hydrogen atom in an amount of not more than 1 atomic %.

2. A valve lifter as claimed in Claim 1, wherein the at least one of a lubricating oil and a lubricant contains at least one friction modifier selected from the group consisting of ashless fatty acid ester friction modifier and ashless aliphatic amine friction modifier.

3. A valve lifter as claimed in Claim 2, wherein the at least one friction modifier has a C₆-C₃₀ hydrocarbon chain and is contained in an amount of 0.05 to 3.0 % by mass based on a total mass of the at least one of a lubricating oil and a lubricant.

4. A valve lifter as claimed in Claim 2 or 3, wherein the at least one of a lubricating oil and a lubricant contains at least one compound selected from the group consisting of polybutenyl succinimide and a derivative of polybutenyl succinimide.

5. A valve lifter as claimed in Claim 4, wherein the at least one compound selected from the group consisting of polybutenyl succinimide and a derivative of polybutenyl succinimide is contained in an amount of 0.1 to 15 % by mass based on a total mass of the one of the lubricating oil and lubricant.

6. A valve lifter as claimed in any of Claims 2 to 5, wherein the lubricating oil contains zinc dithiophosphate in an amount of 0.1 % or less by mass in terms of a phosphorus element based on a total mass of the at least one of a lubricating oil and a lubricant.

7. A valve lifter as claimed in Claim 1, wherein the lubricant has a main component which is a compound containing hydroxyl group.

8. A valve lifter as claimed in any of Claims 1 to 7, wherein the compound is at least one of alcohols.

9. A valve lifter as claimed in Claim 8, wherein the at least of alcohols is at least one of glycerol and ethylene glycol.

10. A valve lifter as claimed in Claim 1, wherein the main body (1b) includes a top wall section and a side wall section which are integral with each other, the top wall section having the top surface, the side wall section having the side surface.

11. A method of producing a valve lifter (1) for an internal combustion engine, comprising:
preparing a main body (1b) of the valve lifter, formed of one of an aluminum alloy and an iron-based alloy as a base material and having a top surface and a side surface; and
forming a hard carbon thin film (1a) on the main body to cover the top surface and the side surface by a PVD process, the hard carbon thin film containing hydrogen atom in an amount of not more than 1 atomic %.

## Patentansprüche

1. Ventilstößel (1) für einen Verbrennungsmotor, umfassend
einen Grundkörper (1b), der aus einer Aluminiumlegierung oder einer auf Eisen basierenden Legierung als Grundmaterial gebildet ist und der eine obere Stirnfläche und eine Seitenfläche aufweist, die in Gegenwart mindestens eines Schmieröls und/oder Schmiermittels jeweils in Gleitkontakt zu Reibungspartnem stehen; und
eine dünne Schicht aus Hartkohlenstoff (1a), die auf dem Grundkörper gebildet ist, so dass sie die obere Stirnfläche und die Seitenfläche bedeckt, wobei die dünne Schicht aus Hartkohlenstoff nicht mehr als 1 Atom-% Wasserstoffatome enthält.

2. Ventilstößel nach Anspruch 1, wobei das mindestens eine Schmieröl und/oder Schmiermittel mindestens einen Reibminderer enthält, der aus der Gruppe umfassend Reibminderer in Form von Fettsäureester und Reibminderer in Form aschefreier aliphatischer Amine ausgewählt ist.

3. Ventilstößel nach Anspruch 2, wobei der mindestens eine Reibminderer eine C₆-C₂₀-Kohlenwasserstoffkette aufweist und in einer Menge von 0.05 bis 3.0 Masse-% bezogen auf die Gesamtmasse des mindestens einen Schmieröls und/oder Schmiermittels enthalten ist.

4. Ventilstößel nach Anspruch 2 oder 3, wobei das mindestens eine Schmieröl und/oder Schmiermittel mindestens eine Verbindung ausgewählt aus der Gruppe umfassend Polybutenylsuccinimid und ein Polybutenylsuccinimid-Derivat enthält.

5. Ventilstößel nach Anspruch 4, worin die mindestens eine aus der Gruppe umfassend Polybutenylsuccinimid und ein Polybutenylsuccinimid-Derivat ausgewählte Verbindung in einer Menge von 0.1 bis 15 Masse-% bezogen auf die Gesamtmasse des mindestens einen Schmieröls und/oder Schmiermittels enthalten ist.

6. Ventilstößel nach einem der Ansprüche 2 bis 5, wobei das Schmieröl Zinkdithiophosphat hinsichtlich eines Elements Phosphor in einer Menge von 0.1 oder weniger Masse-% bezogen auf die Gesamtmasse des mindestens einen Schmieröls und/oder Schmiermittels enthält.

7. Ventilstößel nach Anspruch 1, wobei das Schmiermittel einen Hauptbestandteil aufweist, welches eine Hydroxylgruppe enthaltende Verbindung ist.

8. Ventilstößel nach einem der Ansprüche 1 bis 7, wobei die Verbindung wenigstens ein Alkohol ist.

9. Ventilstößel nach Anspruch 8, wobei der wenigstens eine Alkohol Glycerin und/oder Ethylenglycol ist.

10. Ventilstößel nach Anspruch 1, wobei Grundkörper (1b) einen Stirnwandbereich und einen Seitenwandbereich umfasst, die miteinander einstückig sind und der Stimwandbereich die obere Stirnfläche aufweist und der Seitenwandbereich die Seitenfläche aufweist.

11. Verfahren zur Herstellung eines Ventilstößels (1) für einen Verbrennungsmotor, umfassend
(a) Bereitstellen eines Grundkörpers (1b) des Ventilstößels, der aus einer Aluminiumlegierung oder einer auf Eisen basierenden Legierung gebildet ist und eine obere Stirnfläche und eine Seitenfläche aufweist; und
(b) Bilden einer dünnen Schicht (1a) aus Hartkohlenstoff auf dem Grundkörper mittels eines PVD-Verfahrens, so dass die obere Stirnfläche und die Seitenfläche bedeckt werden, wobei die dünne Schicht aus Hartkohlenstoff nicht mehr als 1 Atom-% Wasserstoffatome enthält.

## Revendications

1. Poussoir de soupape (1) pour moteur à combustion interne, comprenant
un corps principal (1b) formé de l'un parmi un alliage d'aluminium et un alliage à base de fer en tant que matériau de base et ayant une surface supérieure et une surface latérale qui sont respectivement en contact coulissant avec des éléments opposés en présence d'au moins l'un parmi une huile lubrifiante et un lubrifiant ; et
un film mince en carbone dur (1a) formé sur le corps principal pour couvrir la surface supérieure et la surface latérale, le film mince en carbone dur contenant des atomes d'hydrogène en une quantité ne dépassant pas 1 % atomique.

2. Poussoir de soupape selon la revendication 1, dans lequel l'au moins l'un parmi une huile lubrifiante et un lubrifiant contient au moins un agent modifiant le coefficient de frottement choisi dans le groupe constitué par les modificateurs de coefficient de frottement de type acide gras sans cendre et les modificateurs de coefficient de frottement de type amine aliphatique sans cendre.

3. Poussoir de soupape selon la revendication 2, dans lequel l'au moins un modificateur de coefficient de frottement a une chaîne hydrocarbonée en C₆-C₃₀ et est présent en une quantité de 0,05 à 3,0 % en masse par rapport à la masse totale de l'au moins parmi une huile lubrifiante et un lubrifiant.

4. Poussoir de soupape selon la revendication 2 ou 3, dans lequel l'au moins un parmi une huile lubrifiante et un lubrifiant contient au moins un composé choisi dans le groupe constitué par le polybuténylsuccinimide et un dérivé de polybuténylsuccinimide.

5. Poussoir de soupape selon la revendication 4, dans lequel l'au moins un composé choisi dans le groupe constitué par le polybuténylsuccinimide et un dérivé de polybuténylsuccinimide est présent en une quantité de 0,1 à 15 % en masse par rapport à la masse totale de l'au moins parmi une huile lubrifiante et un lubrifiant.

6. Poussoir de soupape selon l'une quelconque des revendications 2 à 5, dans lequel l'huile lubrifiante contient du dithiophosphate de zinc en une quantité de 0,1 % ou moins en masse en termes de phosphore élémentaire par rapport à la masse totale de l'au moins parmi une huile lubrifiante et un lubrifiant..

7. Poussoir de soupape selon la revendication 1, dans lequel le lubrifiant a un composant principal qui est un composé contenant un groupe hydroxyle.

8. Poussoir de soupape selon l'une quelconque des revendications 1 à 7, dans lequel le composé est au moins un alcool.

9. Poussoir de soupape selon la revendication 8, dans lequel l'au moins un alcool est au moins l'un parmi le glycérol et l'éthylèneglycol.

10. Poussoir de soupape selon la revendication 1, dans lequel le corps principal (1b) comprend une section de paroi supérieure et une section de paroi latérale qui sont solidaires l'une de l'autre, la section de paroi supérieure ayant la surface supérieure, et la section de paroi latérale ayant la surface latérale.

11. Procédé pour produire un poussoir de soupape (1) pour un moteur à combustion interne, comprenant :
la préparation d'un corps (1 b) du poussoir de soupape, formé de l'un parmi un alliage d'aluminium et un alliage à base de fer en tant que matériau de base et ayant une surface supérieure et une surface latérale, et
la formation d'un film mince en carbone dur (1a) formé sur le corps principal pour couvrir la surface supérieure et la surface latérale, par un procédé PVD, le film mince en carbone dur contenant des atomes d'hydrogène en une quantité ne dépassant pas 1 % atomique.
